Europäisches Patentamt

European Patent Office

Office européen des brevets

(11) Publication number: **0 431 170 A1**

## (12) EUROPEAN PATENT APPLICATION
### published in accordance with Art. 158(3) EPC

(21) Application number: 90905625.1

(22) Date of filing: 30.03.90

(86) International application number: PCT/JP90/00443

(87) International publication number: WO 90/15023 (13.12.90 90/28)

(51) Int. Cl.5: **C01G 3/00, C01G 15/00, C01G 29/00**

(30) Priority: 27.05.89 JP 133343/89
29.05.89 JP 135620/89
29.05.89 JP 135621/89

(43) Date of publication of application:
**12.06.91 Bulletin 91/24**

(84) Designated Contracting States:
**DE FR GB IT**

(71) Applicant: **FOUNDATIONAL JURIDICAL PERSON INTERNATIONAL SUPERCONDUCTIVITY TECHNOLOGY CENTER**
**34-3, Shinbashi 5-chome**
**Minato-ku Tokyo 105(JP)**

Applicant: **NGK SPARK PLUG CO., LTD**
**14-18, Takatsuji-cho**
**Mizuho-ku Nagoya-shi Aichi 454(JP)**

(72) Inventor: **MASUDA, H Nag.Div.,F.J.P.I.S.T. Center**
**4-1, Mutsuno 2-chome,Atsuta-ku Nagoya-shi Aicha 456(JP)**
Inventor: **MIZUNO, F Nag.Div.,F.J.I.S.T. Center**
**4-1, Mutsuno 2-chome, Atsuta-ku Nagoya-shi Aicha 456(JP)**
Inventor: **HIRABAYASHI, I Nag.Div, F.J.P.I.S.T. Center**
**4-1, Mutsuno 2-chome, Atsuta-ku Nagoya-shi Aicha 456(JP)**
Inventor: **TANAKA, S Nag.Div., F.J.P.I.S.T. Center**
**4-1, Mutsuno 2-chome, Atsuta-ku Nagoya-shi Aicha 456(JP)**

(74) Representative: **Patentanwälte Grünecker, Kinkeldey, Stockmair & Partner**
**Maximilianstrasse 58**
**W-8000 München 22(DE)**

(54) OXIDE SUPERCONDUCTOR.

(57) An oxide superconductor of the molecular formula: $MBa_{2-x}Ca_xCu_3O_{7-x}$, wherein M represents La, etc., and $0 < x \leq 1.8$ except the case where $x = 1.0$. Other examples of the superconductor include those prepared by adding at least one member selected from the group consisting of $Ca_2CuO_3$, $CaCu_2O_3$ and $CaO$ in a total amount of 0.01 to 60 % by weight to 1 mol of $MBa_2Cu_3O_{7-x}$, 1 mol of at least one member selected from the group consisting of $Tl_2Ca_2Ba_2Cu_3Oy$, $Tl_1Ca_2Ba_2Cu_3Oy$, $(Tl, Pb)_1(Sr, Ca)_4Cu_3Oy$, and $(Tl, Pb)_1(Sr, Ca)_3Cu_2Oy$, or 1 mol of $(Bi, Pb)_2Sr_2Ca_2Cu_3Oy$ or/and $Bi_2Sr_2Ca_2Cu_3Oy$.

EP 0 431 170 A1

## OXIDE SUPERCONDUCTING MATERIAL

TECHNICAL FIELD:

The present invention relates to an oxide superconducting material, and more particularly, to an oxide superconducting material having a high critical temperature (Tc) and a great transport critical current density (Jc).

BACKGROUND ART:

Recent years have seen the successive developments of oxide superconducting materials having an extremely high critical temperature at which transfer from the normal conducting state to the superconducting state takes place. These oxide superconducting materials have a higher critical temperature than the conventional superconducting materials of alloy or intermetallic compound, and they are expected to be very promising in practical use.

Among known superconducting materials of M-Ba-Cu-O (M = Y or La) are $MBa_2Cu_3O_{7-y}$ and $Y-(Ba_{0.5}Ca_{0.5})_2Cu_3O_{7-y}$ (as disclosed in Japanese Patent Laid-open No. 230565/1988).

The superconducting material of $LaBa_2Cu_3O_{7-y}$, which does not contain Ca, has a transport critical current density (simply referred to as current density herein-after) as low as 10 $A/cm^2$ (at 77K), which is too small for practical use. It is known that improvement can be made by the addition of $Ag_2O$. Unfortunately, $Ag_2O$ is expensive and its effect is not necessarily satisfactory. (Jpn. J. Appl. Phys. 28, 5 (1989))

Not all the Ca-containing superconducting materials of $Y(Ba_{0.5}Ca_{0.5})_2Cu_3O_{7-y}$ mentioned above have a sufficiently high current density, and hence they need improvement.

Conventional oxide superconducting materials have a critical temperature which differs depending on the element they contain, i.e., about 90K in the case of Y and 110K(upper limit) in the case of Bi. Superconducting materials containing Tl have a critical temperature of 120-125K, which is a record high attained so far. Among the known Tl-containing superconducting materials is $Tl_2Ca_2Ba_2Cu_3Oy$.

This Tl-containing superconducting materials needs a care in its handling owing to the toxicity of Tl; therefore, it has not been thoroughly tested for transfer critical current density (referred to as Jct hereinafter). Its Jct measured at 77K was low compared with its high critical temterature (referred to as Tc herein after). So, this superconducting material is not of practical use. For this reason, there has been a demand for the development of a Tl-containing oxide superconducting material having a high Jct

As mentioned above, conventional oxide superconductingmaterials have a Tc of about 90K when they contain Y and a Tc of 110K(upper limit) when they contain Bi. It is considered that Bi-containing ones are suitable for practical use in liquefied nitrogen. Moreover, they are less expensive because they contain no rare earth elements (metals).

On the other hand, the Bi-containing superconducting material suffers from a disadvantage that the bulk sintered body has a low Jct at 77k. Improvements are being made by floating zone melting or laser-assisted control of melt orientation, which promotes the unidirectional growth of the superconducting phase and eliminates the weak bond of the grain boundary. Moreover, in the case of the Bi-containing superconducting material, unlike in the case of the Y-containing one, the twin crystal dose not play the role of the pinning center of the magnetic flux. In fact, what does the role is the minute cleavage plane (a-b plane) in the crystal. For this reason, there has been a demand for the development of a practical Bi-containing oxide superconducting material having a high Jct.

It is an object of the present invention to provide an oxide superconducting material which has a high critical temperature and a great current density owing to its composition different from that of conventional superconducting materials. Particularly, the third and fourth inventions are intended to provide a very practical oxide superconducting material which is improved in current density while keeping a high critical temperature.

It is another object of the present invention to provide a very practical oxide superconducting material which is improved in Jct while keeping a high Tc.

It is further another object of the present invention to provide a very practical oxide superconducting material which is improved in Jct by the improvement of grain boundary while keeping a high Tc.

DISCLOSURE OF THE INVENTION:

The first invention covers an oxide superconducting material represented by the composition formula of

2

$MBa_{2-x}Ca_x Cu_3O_{7-y}$ (where M denotes at least one species of lanthanoid elements (excluding Ce, Pr, Pm, and Tb) and Sc and Y; and x is in the range of $0<x\leq1.8$ [excluding $x=1.0$]).

The reason why the values of x are limited as above is that there are known superconducting materials in which the values of x are 0 and 1.0. Another reason is that with the value of x higher than 1.9, the material is merely an insulator and does not exhibit the superconducting properties. The material exhibits the good performance (both critical temperature and current density) only when the value of x is greater than 0 and not more than 1.8.

The second invention covers the same oxide superconducting material as in the first invention except that the value of x is in the range of from 0.1 to 0.5. This one has a high critical temperature and yet has a higher transport critical current density than the coventional ones of similar kind. Therefore, it is of great practical use.

The third invention covers a superconducting material which contain 0.01-60 wt% of at least one species of $CaCu_2O_3$ , $Ca_2CuO$, and $CaO$ for one mole of a compound represented by the composition formula of $MBa_2Cu_3O_{7-y}$. The percentage of the additive was specified for the following reasons. With an amount not more than 0.005 wt%, the additive does not make a sufficient improvement in current density. With an amount not less than 0.01 wt%, the additive makes a significant improvement in current density. If only one species is added not less than 70 wt%, the resulting product is an insulator. If two or more species are added not less than 75 wt%, the resulting product has a low critical temperature and current density. Only with an amount of 0.01-60 wt%, the additive increases the current density to a great extent while keeping the high critical temperature.

The fourth invention covers a superconducting material as mentioned above in which M is at least one species of La, Sc and Y. Since these elements are common, the superconducting material is practical and inexpensive. The one containing La is desirable from this point of view.

The superconducting material of the first invention is represented by an oxide composition of $MBa_{2-x}Ca_x Cu_3O_{7-y}$ (where M is La or the like, and x is in the range as specified above. Having a novel composition, the superconducting material has a high critical temperature and current density which are well balanced. Especially, the superconducting material of the second invention, in which x is in the range of from 0.1 to 0.5 has an extremely high current density and hence is of great practical use. The superconducting material of the third invention, which is formed by sintering a mixture of a compound of $MBa_{2-x} Cu_3O_{7-y}$ and a prescribed amount of $Ca_2CuO_3$ or the like, has a further high current density without any decrease in critical temperatures. Therefore, it is of much more practical use.

The superconducting material of the fourth invention, which contains La or the like, is easy to handle and is of practical use.

The superconducting material of the fifth invention contains 0.01 to 60 wt% (in total) of at least one species of $Ca_2CuO_3$, $CaCu_2O_3$ and $CaO$ for one mole of one or more than one species of $Tl_2Ca_2Ba_2Cu_3Oy$, $Tl_1Ca_2Ba_2Cu_3Oy$, $(Tl,Pb)_1(Sr,Ca)_4Cu_3Oy$, and $(Tl,Pb)_1(Sr,Ca)_3Cu_2Oy$.

The amount of the additive was specified as above for the following reasons. With an amount not more than 0.005 wt%, the additive does not increase Jct sufficiently; but with an amonut not less than 0.01%, the additive greatly increases Jct. With an amount not less than 70 wt%, the additive makes the resulting product an insulator; but with an amount not more than 60 wt%, the additive permits the resulting product to exhibit the superconducting properties.

The superconducting material of the fifth invention has a critical temperature because it contains Tl; moreover, it has a greatly high transport critical current density because it also contains $Ca_2CuO_3$ or the like. Thus it is of highly practical use.

The superconducting material of the sixth invention contains 0.01 to 60 wt% (in total) of at least one species of $Ca_2CuO_3$, $CaCu_2O_3$ and $CaO$ for one mole of one or more than one species of $(Bi,Pb)_2Sr_2Ca_2Cu_3Oy$ and $Bi_2Sr_2Ca_2Cu_3Oy$.

The amount of the additive was specified as above for the following reasons. With an amount not more than 0.005%, the additive does not increase Jct sufficiently; but with an amount not less than 0.01%, the additive greatly increases Jct. With an amount not less than 70 wt%, the additive makes the resulting product an insulator; but with an amount not more than 60 wt%, the additive permits the resulting product to exhibit the superconducting properties. The superconducting material of the sixth invention has a high critical temperature because it contains Bi; moreover, it has a greatly high transport critical current density because it also contains a prescribed amount of one or more than one species of $Ca_2CuO_3$ and $CaCu_2O_3$ - (which are needle crystals) and $CaO$ (which is a plate crystal). These crystal contribute to the improved grain boundary.

Owing to the above-mentioned structure, the superconducting material of the present invention is less expensive than the Y-containing ones and less toxic than the Tl-containing ones. It is of great practical use.

BEST MODE FOR CARRYING OUT THE INVENTION:

The invention will be illustrated by reference to the following examples.

Example 1

This example was intended to investigate the effect of the value of x in $LaBa_{2-x}Ca_x Cu_3O_{7-y}$.

First, $La_2O_3$(99.9% pure) which was heated in the air at 800-1000$^\circ$C for 5 hours to prevent it from decomposing into $La_2(OH)_3$. And $Ba(OH)_2 \cdot 8H_2O$ whose purity was determined by gravimetry in the form of $BaSO_4$. CuO (99.9% pure) and $CaCaO_3$ were mixed to the two starting materials in a prescribed ratio so that the resulting mixture has a composition represented by $LaBa_{2-x}Ca_x Cu_3O_{7-y}$ (where $0 \leq x \leq 2.0$) as shown in Table 1.

The resulting mixture was crushed and heated at 800-900 $^\circ$C for 10 hours in air, oxygen, or nitrogen at normal pressure or reduced pressure. The mixture was crushed again and sieved through a 30 $\mu$m screen. Thus there were obtained powders each represented by the composition formula of $LaBa_{2-x}Ca_x Cu_3O_{7-y}$ - (where $0 \leq x \leq 2.0$).

Each powder was formed into a disc, 15 mm in diameter and 1.5 mm thick, by pressing under a pressure of 1-2 tons/ cm$^2$. The green compact was sintered at about 950 $^\circ$C in a furnace in which the pressure was 1.2kg/cm$^2$ and the oxygen partial pressures was 0-100%. The sintering temperature and sintering time are shown in Table 1.

The sintered disk was cut into a square piece, measuring $11 \times 5 \times 1$(thick) mm, which was subsequently coated with gold (about 1$\mu$m thick) by vapor deposition and provided with a four-terminal electrode. To the electrode was soldered an enameled wire (about 0.1 mm in diameter). The solder was coated with an Ag paste, which was subsequently dried in a drier. In this way, samples (Nos. 1 to 21) were prepared. They were tested for characteristic properties (critical temperature Tc end, Tc on, and Tc $_i$ trasport critical current density Jct, and Jc calculated from magnetization hysteresis.) The results are show in Table 2.

Samples (Nos. 22, 23, and 24) were prepared in the same manner as mentioned above, except that La was replaced by Sc, Y, and a combination of La and Y (in equal quantities), respectively. They were evaluated in the same manner as above. The results are also shown in Table 2.

The test piece was tested for electric resistance, with the probe of the cryostat head soldered to it. The values of Tc end measured are shown in Table 2. The test piece was also tested for superconduction transfer

Table 1

| Sample No. | Value of x in $LaBa_{2-x}Ca Cu_3O_7-$ | Sintering temp. (°C) | Sintering time (Hr) |
|---|---|---|---|
| 1 | 0 | 9 6 0 | 2 0 |
| 2 | 0. 1 | 9 4 0 | 1 0 |
| 3 | 0. 2 | 9 3 0 | 1 0 |
| 4 | 0. 3 | 9 4 0 | 1 0 |
| 5 | 0. 4 | 9 4 0 | 1 0 |
| 6 | 0. 5 | 9 5 0 | 1 0 |
| 7 | 0. 6 | 9 4 0 | 1 0 |
| 8 | 0. 7 | 9 4 0 | 1 0 |
| 9 | 0. 8 | 9 3 0 | 1 0 |
| 1 0 | 0. 9 | 9 4 0 | 1 0 |
| 1 1 | 1. 0 | 9 4 0 | 1 0 |
| 1 2 | 1. 1 | 9 3 0 | 1 0 |
| 1 3 | 1. 2 | 9 4 0 | 1 0 |
| 1 4 | 1. 3 | 9 4 0 | 1 0 |
| 1 5 | 1. 4 | 9 3 0 | 1 0 |
| 1 6 | 1. 5 | 9 4 0 | 1 0 |
| 1 7 | 1. 6 | 9 3 0 | 1 0 |
| 1 8 | 1. 7 | 9 4 0 | 1 0 |
| 1 9 | 1. 8 | 9 3 0 | 1 0 |
| 2 0 | 1. 9 | 9 4 0 | 1 0 |
| 2 1 | 2. 0 | 9 4 0 | 1 0 |
| 2 2 | 0. 2(Sc) | 9 5 0 | 1 0 |
| 2 3 | 0. 2(Y) | 9 6 0 | 1 0 |
| 2 4 | 0. 2(La, Y) | 9 5 0 | 1 0 |

Table 2

| Sample No. | Critical temp. | | Transfer critical current density, Jct at 30K, A/cm² | Jc estimated from magnetization hysteresis at 4.2k, A/cm² |
|---|---|---|---|---|
| | $Tc_{end}$ (K) | $Tc_I$ (K) | | |
| 1 | 92 | 91 | 40 | $4.5 \times 10^5$ |
| 2 | 89 | 88 | 170 | 3.8 |
| 3 | 87 | 87 | 190 | 9.4 |
| 4 | 80 | 78 | 180 | 7.8 |
| 5 | 80 | 81 | 120 | 4.2 |
| 6 | 77 | 79 | 120 | 3.7 |
| 7 | 76 | 78 | 100 | 3.0 |
| 8 | 76 | 78 | 90 | 2.0 |
| 9 | 70 | 72 | 100 | 2.0 |
| 10 | 69 | 70 | 86 | 1.8 |
| 11 | 66 | 67 | 110 | 4.0 |
| 12 | 70 | 71 | 77 | 3.7 |
| 13 | 62 | 65 | 90 | 2.0 |
| 14 | 60 | 62 | 68 | 0.98 |
| 15 | 58 | 60 | 50 | 0.82 |
| 16 | 52 | 53 | 30 | 0.43 |
| 17 | 50 | 52 | 40 | 0.13 |
| 18 | 58 | 60 | 25 | 0.098 |
| 19 | 56 | 58 | 20 | 0.14 |
| 20 | Insula- | — | — | — |
| 21 | tor | — | — | — |
| 22 | 88 | 87 | 200 | 5.5 |
| 23 | 87 | 88 | 190 | 6.1 |
| 24 | 86 | 88 | 180 | 5.5 |

temperature (critical temterature Tc $_I$ due to alternating current magnetic susceptibility, by using a Hartshorn bridge. The transfer critical current density Jct is the maximum value of current obtained in the superconducting state at 30K which occurs when a large current is applied to the test piece, with the threshold value being $10\mu V/cm$. The results are shown in Fig. 2 and Table 2. The measurement of Jc by means of magnetization hysteresis was carried out according to Bean method, which involves applying a magnetic field to a flat test piece, measuring 8×3 ×0.3 (thick) mm, at 4.2K in the direction parallel to the thickness direction. SQUID was used for measurement.

The results indicate that samples (Nos. 20 and 21), whose composition has a great value of x (i.e., 1.9 and 2.0, respectively), do not exhibit the superconducting properties but are insulators. All other samples gave a high critical temperature (above 50K) and a greater current density (Jct not less than 20) than conventional one.

The results also indicate that samples (Nos. 16 to 19), whose composition has a comparatively high value of x (i.e. 1.5 to 1.8) gave a current density not more than 40 which is comparatively small. This is true of sample No. 1, whose composition has a zero value of x. However, sample Nos.2 to 15, whose composition has a value of x from 0.1 to 1.4, gave a great current density.

Especially in the case of samples (Nos. 2 to 6), whose composition has a value of x from 0.1 to 0.5, the current density is as extremly high as not less than 120 and the critical temperature is as high as 77-89K. They are of practical use owing to these well-balanced values. In other words, they have a much higher current density as compared with known materials (test piece No. 1) in which the value of x is 0, and also have a higher current density as compared with known materials (sample No. 11) in which the value of x is 1.0. Moreover, they have a critical temperature which is 11-23 K higher than that of the latter known materials.

In the case where La was replaced by Sc, Y, or La + Y (samples Nos. 22 to 24), the same good performance was obtained as in the case of La.

Example 2

This example was intended to investigate the effect of $Ca_2CuO_3$, $CaCu_2O_3$ and $CaO$. As shown in Table 3, samples (Nos. 1 to 38) were prepared in the same manner as in Example 1 by mixing one mole of a compound (powder) represented by $LaBa_2Cu_3O_{7-y}$ with a prescribed amount of one species of $Ca_2CuO_3$, $CaCu_2O_3$ and $CaO$. The samples were evaluated in the same manner as in Example 1. Incidentally, samples Nos. 37 and 38 were prepared with La replaced by Sc or Y. The results of evaluation are shown in Table 4.

The results indicate that samples (Nos. 12, 24, and 36) incorporated with 70 wt% of the additive are insulators, and that samples (Nos. 1, 13 and 25) incorporated with a very

# Table 3

| Sample No. | Additives for one mole of $LaBa_2Cu_3O_{7-y}$ | | Sintering Temp | Sintering Time |
|---|---|---|---|---|
| | Compound | Amount wt% | (°C) | (Hr) |
| 1 | $Ca_2CuO_3$ | 0.005 | 960 | 20 |
| 2 | | 0.01 | 940 | 16 |
| 3 | | 0.05 | 940 | 16 |
| 4 | | 0.1 | 940 | 16 |
| 5 | | 0.2 | 950 | 16 |
| 6 | | 0.5 | 950 | 16 |
| 7 | | 1.0 | 950 | 16 |
| 8 | | 5.0 | 950 | 16 |
| 9 | | 10.0 | 960 | 16 |
| 10 | | 25.0 | 950 | 16 |
| 11 | | 50.0 | 960 | 16 |
| 12 | | 70.0 | 960 | 10 |
| 13 | $CaCu_2O_3$ | 0.005 | 960 | 28 |
| 14 | | 0.01 | 940 | 10 |
| 15 | | 0.05 | 940 | 10 |
| 16 | | 0.1 | 940 | 10 |
| 17 | | 0.2 | 950 | 10 |
| 18 | | 0.5 | 950 | 10 |
| 19 | | 1.0 | 950 | 10 |
| 20 | | 5.0 | 950 | 10 |
| 21 | | 10.0 | 950 | 10 |
| 22 | | 25.0 | 960 | 10 |
| 23 | | 50.0 | 960 | 10 |
| 24 | | 70.0 | 960 | 20 |
| 25 | $CaO$ | 0.005 | 940 | 10 |
| 26 | | 0.01 | 940 | 10 |
| 27 | | 0.05 | 940 | 10 |
| 28 | | 0.1 | 940 | 10 |
| 29 | | 0.2 | 950 | 10 |
| 30 | | 0.5 | 950 | 10 |
| 31 | | 1.0 | 950 | 10 |
| 32 | | 5.0 | 950 | 10 |
| 33 | | 10.0 | 950 | 10 |
| 34 | | 25.0 | 960 | 10 |
| 35 | | 50.0 | 960 | 10 |
| 36 | | 70.0 | 960 | 20 |
| 37 | $Ca_2cu_1O_3$ | 0.2 | 970 | 10 |
| 38 | | 0.2 | 950 | 10 |

# Table 4

| Sample No. | Critical temp. | | Transfer critical current density, Jct at 30K, A/cm² | Jc estimated from magnetization hysteresis at 4.2K A/cm², x10⁵ |
|---|---|---|---|---|
| | Tc end (K) | Tc i (K) | | |
| 1 | 92 | 91 | 45 | 1.5 |
| 2 | 91 | 91 | 220 | 16 |
| 3 | 90 | 90 | 250 | 18 |
| 4 | 88 | 88 | 270 | 25 |
| 5 | 88 | 87 | 280 | 35 |
| 6 | 88 | 88 | 200 | 9.7 |
| 7 | 88 | 88 | 270 | 1-6 |
| 8 | 87 | 87 | 160 | 7.7 |
| 9 | 84 | 84 | 170 | 8.0 |
| 10 | 80 | 80 | 170 | 7.6 |
| 11 | 60 | 61 | 140 | 6.2 |
| 12 | Insulator | — | — | — |
| 13 | 92 | 91 | 50 | 1.7 |
| 14 | 91 | 90 | 110 | 4.6 |
| 15 | 91 | 91 | 140 | 6.2 |
| 16 | 89 | 90 | 150 | 7.0 |
| 17 | 87 | 88 | 260 | 12 |
| 18 | 87 | 88 | 280 | 42 |
| 19 | 86 | 86 | 260 | 33 |
| 20 | 84 | 84 | 150 | 8.0 |
| 21 | 82 | 84 | 160 | 10 |
| 22 | 78 | 80 | 160 | 9.4 |
| 23 | 50 | 53 | 150 | 8.5 |
| 24 | Insulator | — | — | — |
| 25 | 93 | 92 | 42 | 1.2 |
| 26 | 90 | 90 | 100 | 2.5 |
| 27 | 89 | 89 | 130 | 4.0 |
| 28 | 89 | 89 | 270 | 11 |
| 29 | 89 | 88 | 280 | 15 |
| 30 | 87 | 87 | 290 | 42 |
| 31 | 86 | 86 | 280 | 45 |
| 32 | 82 | 83 | 240 | 30 |
| 33 | 79 | 80 | 170 | 21 |
| 34 | 75 | 77 | 170 | 10 |
| 35 | 70 | 72 | 170 | 9.5 |
| 36 | Insulator | — | — | — |
| 37 | 88 | 90 | 295 | 38 |
| 38 | 89 | 88 | 268 | 45 |

small amount (0.005 wt%) of the additive gave a low current density (Jct and Jc). In either case, the additive does not produce a desired effect. On the other hand, samples (Nos. 2 to 11, 14 to 23, and 26 to 35) incorporated with an adequate amount (0.01 to 50 wt%) of additive gave a high critical temperature and a high current density which are well-balanced.

Samples (Nos. 2 to 10) incorporated with 0.01 to 25.0 wt% of $Ca_2CuO_3$ gave a critical temperature not less than 80K and a current density of 170 to 280. Samples (Nos. 16 to 22) incorporated with 0.1 to 25.0

wt% of $CaCu_2O_3$ gave a critical density not less than 78K and a current density of 150 to 280. Samples-(Nos. 28 to 33) incorporated with 0.1 to 10.0 wt% of CaO gave a critical temperature not less than 79k and a current density of 170 to 290. All of them gave a very high critical temperature and current density (Jct and Jc), and they are of highly practical use.

Further, superconducting materials (Samples Nos. 37 and 38) containing Sc or Y in place of La exhibited the same good performance as those containing La.

Example 3

This example was intended to investigate the effect which is produced when two or three species of $Ca_2CuO_3$, $CaCu_2O_3$, and CaO are added as shown in Table 5. Other conditions are substantially the same as those in Example 2. Incidentally, samples Nos. 29 and 30 contain Sc or Y in

## T a b l e  5

| Sample No. | Additives for one mole of LaBa$_2$Cu$_3$O$_{7-y}$, Amount added (wt%) | | | Sintering Temp (°C) | Sintering Time (Hr) |
|---|---|---|---|---|---|
| | Ca$_2$CuO$_3$ | CaCu$_2$O$_3$ | CaO | | |
| 1 | 0.01 | 0.01 | 0 | 950 | 10 |
| 2 | 0.1 | 0.01 | 0 | 950 | 10 |
| 3 | 0.5 | 0.01 | 0 | 950 | 10 |
| 4 | 5 | 0.01 | 0 | 950 | 10 |
| 5 | 10 | 0.01 | 0 | 950 | 10 |
| 6 | 25 | 0.01 | 0 | 950 | 10 |
| 7 | 50 | 0.01 | 0 | 960 | 20 |
| 8 | 0.01 | 5 | 0 | 940 | 10 |
| 9 | 0.1 | 5 | 0 | 950 | 10 |
| 10 | 0.5 | 5 | 0 | 950 | 10 |
| 11 | 5 | 5 | 0 | 950 | 10 |
| 12 | 10 | 5 | 0 | 950 | 10 |
| 13 | 25 | 5 | 0 | 950 | 10 |
| 14 | 50 | 5 | 0 | 960 | 20 |
| 15 | 0.01 | 25 | 0 | 940 | 10 |
| 16 | 0.1 | 25 | 0 | 950 | 10 |
| 17 | 0.5 | 25 | 0 | 950 | 10 |
| 18 | 5 | 25 | 0 | 950 | 10 |
| 19 | 10 | 25 | 0 | 950 | 10 |
| 20 | 25 | 25 | 0 | 960 | 10 |
| 21 | 50 | 25 | 0 | 960 | 20 |
| 22 | 0.01 | 5 | 0.01 | 950 | 10 |
| 23 | 0.1 | 5 | 0.5 | 950 | 10 |
| 24 | 0.5 | 5 | 1.0 | 950 | 10 |
| 25 | 5 | 5 | 5.0 | 950 | 10 |
| 26 | 10 | 5 | 10.0 | 950 | 10 |
| 27 | 25 | 5 | 25.0 | 950 | 10 |
| 28 | 50 | 5 | 50.0 | 960 | 20 |
| 29 | 5 (Sc) | 5 | 0 | 950 | 10 |
| 30 | 5 (Y) | 5 | 0 | 950 | 10 |

T a b l e    6

| Sample No. | Critical temp. $Tc_{end}$ (K) | Transfer critical current density, Jct at 30K, A/cm² |
|---|---|---|
| 1 | 9 0 | 2 3 0 |
| 2 | 8 8 | 2 2 0 |
| 3 | 8 8 | 2 4 0 |
| 4 | 8 8 | 2 1 0 |
| 5 | 8 5 | 2 2 0 |
| 6 | 8 0 | 1 8 0 |
| 7 | 6 0 | 1 6 0 |
| 8 | 8 7 | 2 1 0 |
| 9 | 8 7 | 2 5 0 |
| 1 0 | 8 6 | 2 8 0 |
| 1 1 | 8 4 | 2 8 0 |
| 1 2 | 8 4 | 2 3 0 |
| 1 3 | 8 0 | 2 2 0 |
| 1 4 | 5 5 | 1 2 0 |
| 1 5 | 8 0 | 2 0 0 |
| 1 6 | 8 0 | 1 8 0 |
| 1 7 | 7 8 | 1 7 0 |
| 1 8 | 7 7 | 2 0 0 |
| 1 9 | 7 8 | 2 2 0 |
| 2 0 | 7 6 | 1 6 0 |
| 2 1 | 5 0 | 2 2 |
| 2 2 | 9 0 | 2 0 0 |
| 2 3 | 8 8 | 1 8 0 |
| 2 4 | 8 7 | 2 0 0 |
| 2 5 | 8 4 | 2 1 0 |
| 2 6 | 8 0 | 2 0 0 |
| 2 7 | 7 0 | 1 8 0 |
| 2 8 | 4 2 | 1 6 |
| 2 9 | 8 8 | 2 5 0 |
| 3 0 | 8 7 | 2 7 0 |

place of La. The results of the evaluation of the performance are shown in Table 6.

The results indicate that sample (No. 21) incorporated with 75% (in total) of the additive and sample (No. 28) incorporated with 105 wt% (in total) of the additive gave a low critical temperature and current density. Samples (Nos. 1 to 20 and 22 to 27) incorporated with not more than 50 wt% of additive exhibited good characteristic properties.

It is also noted that two or more additives used in combination produce a better effect of improving critical temperature and, especially, current density than additives used individually. For example, sample No. 21 incorporated with 75 wt% (in total) of additives exhibited the superconducting propereies although it gave impaired performance (both critical temperature and current density). Samples (Nos. 12 and 24 shown in Table 4) incorporated with 70 wt% of a single additive exhibited merely the properties of an insulator. Sample (No. 11) incorporated with 10 wt% of additives in combination gave a current density which is about 65-75% higher than that of samples (Nos. 9 and 21 in Table 4) incorporated with 10 wt% of a single additive. Samples (Nos. 13, 18, 19, and 26) incorporated with 25 to 35 wt% of additive in combination gave a current density which is about 20-40% higher than that of samples (Nos. 10 and 22 shown in Table 4) incorporated with 25 wt% of a single additive. Samples (Nos. 20 and 27) incorporated with 50 to 55 wt% of additives in combination gave a current density which is 6-15% higher than that of samples (Nos. 11, 23, and 35 shown in Table 4) incorporated with 50 wt% of single additive.

This example shows that the combined additives increase the current density without lowering the critical temperature and that the additive can be used in a broad range of amount stable effect on the superconducting properties.

Moreover, samples (Nos. 29 and 30) incorporated with Sc or Y in place of La exhibited the same performance as samples containing La.

The above-mentioned examples are not limitative but may be modified according to the intended object and application within the scope of the invention. For example, La, Sc and Y used in the above-mentioned examples may be replaced by any other lanthanoid elements (such as Nd, Sm, Eu, Gd, Oy, Ho, Er, Tm, Yb and Lu) (excluding Ce, Pr, Pm and Tb) , alone or in combination. In the case of combined use, a combination of $CaCu_2O_3$ and CaO or a combination of $Ca_2CuO_3$ and CaO is also possible. Further, the present invention may be applied to liquid-phase and gas-phase reaction as well as solid phase reaction. In addition, the heat treatment and sintering may be carried out under other conditions (temperature, time, and atmosphere) than those employed in the above-mentioned examples. The starting materials are not specifically limited so long as they give rise to a desired oxide upon heating.

Example 4

This example was intended to investigate the effect of any one compound of $Ca_2CuO_3$, $CaCu_2O_3$ or CaO on the $Tl_2Ca_2Ba_2Cu_3O_y$ compound.

First, $Ca_2CuO_3$, $CaCu_2O_3$ and CaO (99.9% or above) were weighed separately as much as required. Each compound was calcined at 900 °C for 16 hours in as oxygen flow gas. During calcination, the compound was crushed several times. The calcined and crushed compound was mixed with a prescibed amount of $Tl_2O_3$.

Secondly, the resulting powder of Tl compound was further mixed with a prescribed amount (as shown in Table 7) at $Ca_2CuO_3$, $CaCu_2O_3$ or CaO which had been heated in the air at 1000 °C for 10 hours. The resulting powder was formed into a disc, 15mm in diameter and 1.5 mm thick, by pressing under a pressure of 1-2 tons/cm². The green compact was sintered at 860-870 °C for 10 minutes, followed by quenching to room temperature. Sintering was repeated at 880-890 °C for 120 minutes, followed by cooling in the furnace. The sintered disk was crushed to give a powder of Tl-Ca-Ba-Cu-O compound. The sintering temperature and sintering time are shown in Table 7.

The sintered disk was cut into a square piece, measuring $11 \times 5 \times 1$(thick) mm, which was subsequently coated with gold(about $1 \mu$m thick) by vapor desposition and provided with

## Table 7

| Sample No. | Additives for one mole ($Tl_2Ca_2Ba_2Cu_3O_y$) | | First Sintering | | Second Sintering | |
|---|---|---|---|---|---|---|
| | Compound | Amount wt% | Temp. (°C) | Time (min) | Temp. (°C) | Time (min) |
| 1 | None | 0 | 860 | 10 | 890 | 120 |
| 2 | $Ca_2CuO_3$ | 0.005 | 860 | 10 | 890 | 120 |
| 3 | | 0.01 | 860 | 10 | 890 | 120 |
| 4 | | 0.05 | 860 | 10 | 890 | 120 |
| 5 | | 0.1 | 860 | 10 | 890 | 120 |
| 6 | | 0.2 | 860 | 10 | 890 | 120 |
| 7 | | 0.5 | 860 | 10 | 890 | 120 |
| 8 | | 1.0 | 860 | 10 | 890 | 120 |
| 9 | | 5.0 | 870 | 20 | 880 | 120 |
| 10 | | 10.0 | 870 | 20 | 880 | 120 |
| 11 | | 25.0 | 870 | 20 | 880 | 120 |
| 12 | | 50.0 | 870 | 20 | 880 | 120 |
| 13 | | 60.0 | 870 | 20 | 880 | 120 |
| 14 | | 70.0 | 870 | 20 | 880 | 120 |
| 15 | $CaCu_2O_3$ | 0.005 | 860 | 10 | 890 | 120 |
| 16 | | 0.01 | 860 | 10 | 890 | 120 |
| 17 | | 0.05 | 860 | 10 | 890 | 120 |
| 18 | | 0.1 | 860 | 10 | 890 | 120 |
| 19 | | 0.2 | 860 | 10 | 890 | 120 |
| 20 | | 0.5 | 860 | 10 | 890 | 120 |
| 21 | | 1.0 | 860 | 10 | 890 | 120 |
| 22 | | 5.0 | 870 | 20 | 880 | 120 |
| 23 | | 10.0 | 870 | 20 | 880 | 120 |
| 24 | | 25.0 | 870 | 20 | 880 | 120 |
| 25 | | 50.0 | 870 | 20 | 880 | 120 |
| 26 | | 60.0 | 870 | 20 | 880 | 120 |
| 27 | | 70.0 | 870 | 20 | 880 | 120 |
| 28 | CaO | 0.005 | 860 | 10 | 890 | 120 |
| 29 | | 0.01 | 860 | 10 | 890 | 120 |
| 30 | | 0.05 | 860 | 10 | 890 | 120 |
| 31 | | 0.1 | 860 | 10 | 890 | 120 |
| 32 | | 0.2 | 860 | 10 | 890 | 120 |
| 33 | | 0.5 | 860 | 10 | 890 | 120 |
| 34 | | 1.0 | 860 | 10 | 890 | 120 |
| 35 | | 5.0 | 870 | 20 | 880 | 120 |
| 36 | | 10.0 | 870 | 20 | 880 | 120 |
| 37 | | 25.0 | 870 | 20 | 880 | 120 |
| 38 | | 50.0 | 870 | 20 | 880 | 120 |
| 39 | | 60.0 | 870 | 20 | 880 | 120 |
| 40 | | 70.0 | 870 | 20 | 880 | 120 |

T a b l e   8

| Sample No. | Critical temp. Tc (K) | Transfer critical current density, Jct at 77K, A/cm$^2$ |
|---|---|---|
| 1 | 1 2 5 | 1 2 5 |
| 2 | 1 2 5 | 1 6 0 |
| 3 | 1 2 4 | 1 9 5 0 |
| 4 | 1 2 4 | 2 1 6 0 |
| 5 | 1 2 3 | 2 2 8 0 |
| 6 | 1 2 4 | 2 6 2 0 |
| 7 | 1 2 5 | 2 7 1 0 |
| 8 | 1 1 9 | 2 8 0 0 |
| 9 | 1 1 8 | 2 2 5 0 |
| 1 0 | 1 1 7 | 2 2 3 0 |
| 1 1 | 1 0 9 | 1 8 0 0 |
| 1 2 | 9 8 | 1 2 5 0 |
| 1 3 | 8 7 | 7 3 0 |
| 1 4 | Insulator | — |
| 1 5 | 1 2 5 | 1 1 5 |
| 1 6 | 1 2 3 | 1 7 0 0 |
| 1 7 | 1 2 2 | 1 6 5 0 |
| 1 8 | 1 2 3 | 1 7 0 0 |
| 1 9 | 1 2 2 | 1 5 8 0 |
| 2 0 | 1 2 3 | 1 6 9 0 |
| 2 1 | 1 1 8 | 1 8 3 0 |
| 2 2 | 1 1 7 | 1 7 5 0 |
| 2 3 | 1 1 5 | 1 4 5 0 |
| 2 4 | 1 0 6 | 1 5 0 0 |
| 2 5 | 8 9 | 1 2 5 0 |
| 2 6 | 8 7 | 9 0 0 |
| 2 7 | Insulator | — |
| 2 8 | 1 2 5 | 1 0 0 |
| 2 9 | 1 2 3 | 1 7 0 0 |
| 3 0 | 1 2 5 | 1 6 5 0 |
| 3 1 | 1 2 4 | 1 7 0 0 |
| 3 2 | 1 2 3 | 1 6 2 0 |
| 3 3 | 1 2 3 | 1 3 0 0 |
| 3 4 | 1 1 8 | 1 4 9 0 |
| 3 5 | 1 1 6 | 1 2 8 0 |
| 3 6 | 1 1 5 | 1 1 9 0 |
| 3 7 | 1 1 0 | 1 1 8 0 |
| 3 8 | 9 0 | 8 7 0 |
| 3 9 | 8 7 | 7 6 0 |
| 4 0 | Insulator | — |

a four-terminal electrode. To the electrode was soldered an enameled wire (about 0.1 mm in diameter). The solder was coated with an Ag paste, which was subsequently dried in a drier. In this way, samples (Nos. 1 to 40) were prepared. They were tested for characteristic properties (Tc and Jct) in the following manner. The results are shown in Table 8.

The test piece was tested for electric resistance, with the probe of the cryostat head soldered to it. The Jc is the maximum value of current obtained in the superconducting state at 77K which occurs when a large current is applied to the test piece, with the threshould value being $10\mu V/cm$.

The results indicate the following. Samples (Nos.14, 27, and 40) incorporated with 70 wt% (moer than 60 wt%) of $Ca_2CuO_3$, $CaCu_2O_3$ or CaO do not exhibit the superconducting properties but are insulators. Sample (No.1) containing no additive and samples (Nos. 2, 15, and 28) containing only a small amount 0.005%) of additive gave low values of Jct. Samples (Nos. 3to 14, 16 to 27, and 29 to 39) incorporated with the additive in an amount of 0.01 to 50 wt% are superior in Jct to conventional superconducting materials, despite their slightly lower critical temperature. The value obtained when the amount added is 0.01 wt% is 14 to 16 times larger than that obtained when nothing is added. This suggests how effective the additive is.

It is particularly noted that samples (Nos. 3 to 12 and 16 to 25) incorporated with 0.01 to 50.0 wt% of $Ca_2CuO_3$ or $CaCu_2O_3$ gave an extremely high value of Jct (1250 or above ), and that samples (Nos. 29 to 37) incorporated with 0.01 to 25.0 wt% of CaO also gave an extremely high value of Jct (1180 or above). They are of great practical use.

Example 5

This example was intended to investigate the effect which is produced when two or three species of $Ca_2CuO_3$, $CaCu_2O_3$ and CaO are added as shown in Table 9. Other conditions are substantially the same as those in Example 1. The results are shown in Table 10.

Samples (Nos. 1 to 15) were prepared by adding $Ca_2CuO_3$ and $CaCu_2O_3$, and samples (Nos. 16 to 35) were prepared by adding $Ca_2CuO_3$, $CaCu_2O_3$, and CaO. The results indicate the following. Samples incorporated with the additives in combination in an amount more than specified (60 wt%) are all insulators. (For example, sample No. 15 incorporated with 75 wt%, samples Nos.25 and 34 incorporated with 80 wt% , and sample No.35 incorporated with 105 wt%.) Samples(Nos. 1 to 14, 16 to 24, 26, 27 and 32) incorporated with the additives in combination in a specified amount (0.02 to 55 wt%) exhibit the good properties of superconducting material.

Samples (Nos. 1 to 14) incorporated with not more than 50 wt% of $Ca_2CuO_3$ and $CaCu_2O_3$ in combination gave a Tc not less than 87K and a Jc as high as 1000 or above. Samples (

## Table 9

| Sample No. | Additives for one mole of $Tl_2Ca_2Ba_2Cu_3O_y$ (wt%) | | | First Sintering | | Second Sintering | |
|---|---|---|---|---|---|---|---|
| | $Ca_2CuO_3$ | $CaCu_2O_3$ | $CaO$ | Temp. (°C) | Time (min) | Temp. (°C) | Time (min) |
| 1 | 0.01 | 0.01 | 0 | 860 | 10 | 890 | 120 |
| 2 | 0.5 | 0.01 | 0 | 860 | 10 | 890 | 120 |
| 3 | 10 | 0.01 | 0 | 860 | 10 | 890 | 120 |
| 4 | 25 | 0.01 | 0 | 860 | 10 | 890 | 120 |
| 5 | 50 | 0.01 | 0 | 860 | 10 | 890 | 120 |
| 6 | 0.01 | 10 | 0 | 870 | 10 | 880 | 120 |
| 7 | 0.5 | 10 | 0 | 870 | 10 | 880 | 120 |
| 8 | 10 | 10 | 0 | 870 | 10 | 880 | 120 |
| 9 | 25 | 10 | 0 | 870 | 10 | 880 | 120 |
| 10 | 50 | 10 | 0 | 870 | 10 | 880 | 120 |
| 11 | 0.01 | 25 | 0 | 870 | 10 | 880 | 120 |
| 12 | 0.5 | 25 | 0 | 870 | 10 | 880 | 120 |
| 13 | 10 | 25 | 0 | 870 | 10 | 880 | 120 |
| 14 | 25 | 25 | 0 | 870 | 10 | 880 | 120 |
| 15 | 50 | 25 | 0 | 870 | 10 | 880 | 120 |
| 16 | 0.01 | 5 | 0.01 | 860 | 10 | 890 | 120 |
| 17 | 0.5 | 5 | 0.01 | 860 | 10 | 890 | 120 |
| 18 | 10 | 5 | 0.01 | 860 | 10 | 890 | 120 |
| 19 | 25 | 5 | 0.01 | 860 | 10 | 890 | 120 |
| 20 | 50 | 5 | 0.01 | 860 | 10 | 890 | 120 |
| 21 | 0.01 | 5 | 25 | 860 | 10 | 890 | 120 |
| 22 | 0.5 | 5 | 25 | 860 | 10 | 890 | 120 |
| 23 | 10 | 5 | 25 | 860 | 10 | 890 | 120 |
| 24 | 25 | 5 | 25 | 860 | 10 | 890 | 120 |
| 25 | 50 | 5 | 25 | 860 | 10 | 890 | 120 |
| 26 | 0.01 | 5 | 50 | 870 | 10 | 880 | 120 |
| 27 | 0.5 | 5 | 50 | 870 | 10 | 880 | 120 |
| 28 | 10 | 5 | 50 | 870 | 10 | 880 | 120 |
| 29 | 25 | 5 | 50 | 870 | 10 | 880 | 120 |
| 30 | 50 | 5 | 50 | 870 | 10 | 880 | 120 |
| 31 | 0.01 | 50 | 5 | 870 | 10 | 880 | 120 |
| 32 | 0.5 | 50 | 5 | 870 | 10 | 880 | 120 |
| 33 | 10 | 50 | 5 | 870 | 10 | 880 | 120 |
| 34 | 25 | 50 | 5 | 870 | 10 | 880 | 120 |
| 35 | 50 | 50 | 5 | 870 | 10 | 880 | 120 |

Table 10

| Sample No | Critical temp. Tc end (K) | Transfer critical current density, Jct at 77K, A/cm² |
|---|---|---|
| 1 | 124 | 1850 |
| 2 | 125 | 2800 |
| 3 | 116 | 2100 |
| 4 | 106 | 1500 |
| 5 | 100 | 1400 |
| 6 | 118 | 1950 |
| 7 | 117 | 1800 |
| 8 | 116 | 1700 |
| 9 | 105 | 1600 |
| 10 | 90 | 950 |
| 11 | 106 | 1880 |
| 12 | 106 | 1760 |
| 13 | 102 | 1480 |
| 14 | 87 | 1000 |
| 15 | Insulator | — |
| 16 | 118 | 2010 |
| 17 | 117 | 2100 |
| 18 | 114 | 1250 |
| 19 | 102 | 1190 |
| 20 | 86 | 780 |
| 21 | 106 | 1830 |
| 22 | 105 | 1890 |
| 23 | 100 | 1500 |
| 24 | 85 | 690 |
| 25 | Insulator | — |
| 26 | 87 | 760 |
| 27 | 87 | 770 |
| 28 | 76 | — |
| 29 | Insulator | — |
| 30 | Insulator | — |
| 31 | 82 | 700 |
| 32 | 80 | 370 |
| 33 | 68 | — |
| 34 | Insulator | — |
| 35 | Insulator | — |

Nos. 16 to 23) incorporated with not more than 40 wt% of $Ca_2CuO_3$, $CaCu_2O_3$ and CaO in combination gave a Tc not less than 100K and a Jct as high as 1500 or above. They are of extremely practical use.

The above-mentioned examples are not limitative but may be modified according to the intended object and application within the scope of the invention. For example, the Tl compound to which the additives ($Ca_2CuO_3$ etc.) are added may be replaced by $Tl_1Ca_2Ba_2Cu_3O_y$, $(Tl,Pb)_1(Sr,Ca)_4Cu_3O_y$, or $(Tl,Pb)_1(Sr,Ca)_3Cu_2O_y$, or a combination of these compounds and the compound used in this example.

The combination of the additives ($Ca_2CuO_3$, $CaCu_2O_3$, and CaO) is not limited to that shown above; but a combination of $CaCu_2O_3$ and CaO or a combination of $Ca_2CuO_3$ and CaO is also possible. In addition, the heat treatment and sintering may be carried out under other conditions (temperature, time and atmosphere) than those employed in the above-mentioned examples. The starting materials are not specifically limited so long as they give rise to a desired oxide upon heating.

Example 6

This example was intended to investigate the effect of any one compound of $Ca_2CuO_3$, $CaCu_2O_3$ and CaO to one mole of $(Bi, Pb)_2Sr_2Ca_2Cu_3O_y$.

First, a mixture was prepared from $Bi_2O_3$, $Pb_3O_4$, $SrCO_3$ , $CaCO_3$ and CuO (99.9% or above) in such a ratio that $Bi:Pb:Sr:Ca:Cu = 1.85:0.35:1.9:2.1:3.1$ (for example). The mixture was calcined at 830 °C for 20 hours in the air, followed by crushing.

Secondly, each powder of $Ca_2CuO_3$, $CaCu_2O_3$, and CaO was weighed as much as required as shown in Table 11. The weighed powder was added to the above-mentioned Bi-containing compound. The resulting powder mixture was formed into a disc, 15 mm in diameter and 1.5 mm thick, by pressing under a pressure of 1-2 tons/cm². The green compact was sintered at 860-870 °C for 100-200 hours in a nitrogen flow gas. In this stage, the single 2223 phase was formed (110K high-temperature phase). The sintered disk (which has a low density) was crushed to give a powder which was press-formed again, followed by the second sintering at 830 °C for 3 hours. The sintering temperature and sintering time are shown in Table 11.

The sintered disk was cut into a square piece, measuring 11 ×5 ×1(thick) mm, which was subsequently coated with gold (about 1 μm thick) by vapor deposition and provided with a four-terminal electrode. To the electrode was soldered an enameled wire (about 0.1 mm in diameter). The solder was coated with an Ag paste, which was subsequently dried in a drier. In this way, Nos. 1 to 40 were prepared. They were tested for charactristic properties (Tc and Jct) in thefollowing manner. The results are shown in Table 12.

## T a b l e   1 1

| Sample No. | Additives for one mole $(TlCa\ Ba_2Cu_3O_x)$ | | First Sintering | | Second Sint'g |
| --- | --- | --- | --- | --- | --- |
| | Compound | Amount wt% | Temp. (°C) | Time (min) | Temp. (°C) |
| 1 | None | | 860 | 10 | 890 |
| 2 | $Ca_2CuO_3$ | 0.005 | 860 | 10 | 890 |
| 3 | | 0.01 | 860 | 10 | 890 |
| 4 | | 0.05 | 860 | 10 | 890 |
| 5 | | 0.1 | 860 | 10 | 890 |
| 6 | | 0.2 | 860 | 10 | 890 |
| 7 | | 0.5 | 860 | 10 | 890 |
| 8 | | 1.0 | 860 | 10 | 890 |
| 9 | | 5.0 | 870 | 20 | 880 |
| 10 | | 10.0 | 870 | 20 | 880 |
| 11 | | 25.0 | 870 | 20 | 880 |
| 12 | | 50.0 | 870 | 20 | 880 |
| 13 | | 60.0 | 870 | 20 | 880 |
| 14 | | 70.0 | 870 | 20 | 880 |
| 15 | $CaCu_2O_3$ | 0.005 | 860 | 10 | 890 |
| 16 | | 0.01 | 860 | 10 | 890 |
| 17 | | 0.05 | 860 | 10 | 890 |
| 18 | | 0.1 | 860 | 10 | 890 |
| 19 | | 0.2 | 860 | 10 | 890 |
| 20 | | 0.5 | 860 | 10 | 890 |
| 21 | | 1.0 | 860 | 10 | 890 |
| 22 | | 5.0 | 870 | 20 | 880 |
| 23 | | 10.0 | 870 | 20 | 880 |
| 24 | | 25.0 | 870 | 20 | 880 |
| 25 | | 50.0 | 870 | 20 | 880 |
| 26 | | 60.0 | 870 | 20 | 880 |
| 27 | | 70.0 | 870 | 20 | 880 |
| 28 | $CaO$ | 0.005 | 860 | 10 | 890 |
| 29 | | 0.01 | 860 | 10 | 890 |
| 30 | | 0.05 | 860 | 10 | 890 |
| 31 | | 0.1 | 860 | 10 | 890 |
| 32 | | 0.2 | 860 | 10 | 890 |
| 33 | | 0.5 | 860 | 10 | 890 |
| 34 | | 1.0 | 860 | 10 | 890 |
| 35 | | 5.0 | 870 | 20 | 880 |
| 36 | | 10.0 | 870 | 20 | 880 |
| 37 | | 25.0 | 870 | 20 | 880 |
| 38 | | 50.0 | 870 | 20 | 880 |
| 39 | | 60.0 | 870 | 20 | 880 |
| 40 | | 70.0 | 870 | 20 | 880 |

Table 12

| Sample No. | Critical temp. Tc (K) | Transfer critical current density, Jct (A/cm$^2$) |
|---|---|---|
| 1 | 1 2 5 | 1 2 5 |
| 2 | 1 2 5 | 1 6 0 |
| 3 | 1 2 4 | 1 9 5 0 |
| 4 | 1 2 4 | 2 1 6 0 |
| 5 | 1 2 3 | 2 2 8 0 |
| 6 | 1 2 4 | 2 6 2 0 |
| 7 | 1 2 5 | 2 7 1 0 |
| 8 | 1 1 9 | 2 8 0 0 |
| 9 | 1 1 8 | 2 2 5 0 |
| 1 0 | 1 1 7 | 2 2 3 0 |
| 1 1 | 1 0 9 | 1 8 0 0 |
| 1 2 | 9 8 | 1 2 5 0 |
| 1 3 | 8 7 | 7 3 0 |
| 1 4 | Insulator | — |
| 1 5 | 1 2 5 | 1 1 5 |
| 1 6 | 1 2 3 | 1 7 0 0 |
| 1 7 | 1 2 2 | 1 6 5 0 |
| 1 8 | 1 2 3 | 1 7 0 0 |
| 1 9 | 1 2 2 | 1 5 8 0 |
| 2 0 | 1 2 3 | 1 6 9 0 |
| 2 1 | 1 1 8 | 1 8 3 0 |
| 2 2 | 1 1 7 | 1 7 5 0 |
| 2 3 | 1 1 5 | 1 4 5 0 |
| 2 4 | 1 0 6 | 1 3 0 0 |
| 2 5 | 8 9 | 1 2 5 0 |
| 2 6 | 8 7 | 9 0 0 |
| 2 7 | Insulator | — |
| 2 8 | 1 2 5 | 1 0 0 |
| 2 9 | 1 2 3 | 1 7 0 0 |
| 3 0 | 1 2 5 | 1 6 5 0 |
| 3 1 | 1 2 4 | 1 7 0 0 |
| 3 2 | 1 2 3 | 1 6 2 0 |
| 3 3 | 1 2 3 | 1 3 0 0 |
| 3 4 | 1 1 8 | 1 4 9 0 |
| 3 5 | 1 1 6 | 1 2 8 0 |
| 3 6 | 1 1 5 | 1 1 9 0 |
| 3 7 | 1 1 0 | 1 1 8 0 |
| 3 8 | 9 0 | 8 7 0 |
| 3 9 | 8 7 | 7 6 0 |
| 4 0 | Insulator | — |

The test piece was tested for electric resistance, with the probe of the cryostat head soldered to it. The Jct is the maximum value of current obtained in the superconducting state at 77K which occurs when a large current is applied tothe test piece, with the threshould value being 10 $\mu$V/cm.

The results indicate the following. Samples(Nos 14, 2 7 and 40) in corporated with 70 wt% (which is more than the upper limil specified in the invention) of $Ca_2CuO_3$, $CaCu_2O_3$ and $CaO$ do not exhibit the superconducting properties but are insulators. Sample (No. 1) containing no additive and samples (Nos. 2, 15, and 28) containing only a small amount (0.005% which is less than the lower limit specified in the invention) of additive gave low values of Jct. Samples ( Nos. 3 to 14, 16 to 27, and 29 to 39) incorporated with the additive in an amount of 0.01 to 50 wt% are superior in Jct to conventional superconducting materials, despite their slightly lower critical temperature. The value obtained even when the amount added is 0.01 wt% is 10 to 13 times larger than that obtained when nothing is added. This suggests how effective the additive is.

It is particularly noted that samples (Nos. 3 to 12 and 16 to 25) incorporated with 0.01 to 50.0 wt% of $Ca_2CuO_3$ or $CaCu_2O_3$ gave an extremly high value of Jct (150 or above) , and that samples (Nos. 29 to 37) incorporated with 0.01 to 50.0 wt% of CaO also gave an extremely high value of Jct (1180 or above). They are of great practical use.


Example 7

This example was intended to investigate the effect which is produced when two or three species of $Ca_2CuO_3$, $CaCu_2O_3$ and CaO are added as shown in Table 13. Other conditions are substantially the same as those in Example 1.

The results are shown in Table 14. Samples (Nos. 1 to 15) were prepared by adding $Ca_2CuO_3$ and $CaCu_2O_3$, and samples (Nos. 16 to 35) were prepared by adding $Ca_2CuO_3$, $CaCu_2O_3$ and CaO.

The results indicate the following. Samples incorporated with the additives in combination in an amount more than specified are all insulators. (For example, sample No. 15 incorporated with 75 wt%, samples Nos. 25, 29 and 34 incorporated with 80 wt%, and samples Nos. 30 and 35 incorporated with 105 wt%.) Samples (Nos. 28 and 33) incorporated with 65 wt% gave a value of Jct which was too small to measure accurately. On the other hand, samples (Nos. 1 to 14, 16 to 24, 26, 27, 31 and 32) incorporated with the additives in combination in a specified amount ( 0.02 to 60 wt%) exhibit the good properties of superconducting material.

Particularly, Samples (Nos. 1 to 9, 11 to 13) incorporated with not more than 35 wt% of $Ca_2CuO_3$ and $CaCu_2O_3$ in combination gave a Tc not less than 92K and a Jc as extremely high as 200 or above. Samples (Nos. 16 to 19 and

## Table 13

| Sample No | Additives for one mole of (Bi,Pb)$_2$Sr$_2$Ca$_2$Cu$_3$O$_y$, wt% | | | First Sinter'g | | Second Sinter'g | |
|---|---|---|---|---|---|---|---|
| | Ca$_2$CuO$_3$ | CaCu$_2$O$_3$ | CaO | Temp. (°C) | Time (Hr) | Temp. (°C) | Time (Hr) |
| 1 | 0.01 | 0.01 | 0 | 860 | 100 | 830 | 3 |
| 2 | 0.5 | 0.01 | 0 | 860 | 100 | 830 | 3 |
| 3 | 10 | 0.01 | 0 | 860 | 100 | 830 | 3 |
| 4 | 25 | 0.01 | 0 | 860 | 100 | 830 | 3 |
| 5 | 50 | 0.01 | 0 | 860 | 100 | 830 | 5 |
| 6 | 0.01 | 10 | 0 | 870 | 100 | 830 | 3 |
| 7 | 0.5 | 10 | 0 | 870 | 100 | 830 | 3 |
| 8 | 10 | 10 | 0 | 870 | 100 | 830 | 3 |
| 9 | 25 | 10 | 0 | 870 | 100 | 830 | 3 |
| 10 | 50 | 10 | 0 | 870 | 100 | 830 | 3 |
| 11 | 0.01 | 25 | 0 | 870 | 100 | 830 | 3 |
| 12 | 0.5 | 25 | 0 | 870 | 100 | 830 | 3 |
| 13 | 10 | 25 | 0 | 870 | 100 | 830 | 3 |
| 14 | 25 | 25 | 0 | 870 | 100 | 830 | 3 |
| 15 | 50 | 25 | 0 | 870 | 100 | 830 | 5 |
| 16 | 0.01 | 5 | 0.01 | 860 | 100 | 830 | 3 |
| 17 | 0.5 | 5 | 0.01 | 860 | 100 | 830 | 3 |
| 18 | 10 | 5 | 0.01 | 860 | 100 | 830 | 3 |
| 19 | 25 | 5 | 0.01 | 860 | 100 | 830 | 5 |
| 20 | 50 | 5 | 0.01 | 860 | 100 | 830 | 3 |
| 21 | 0.01 | 5 | 25 | 870 | 100 | 830 | 3 |
| 22 | 0.5 | 5 | 25 | 870 | 100 | 830 | 3 |
| 23 | 10 | 5 | 25 | 870 | 100 | 830 | 3 |
| 24 | 25 | 5 | 25 | 870 | 100 | 830 | 3 |
| 25 | 50 | 5 | 25 | 870 | 100 | 830 | 5 |
| 26 | 0.01 | 5 | 50 | 870 | 200 | 830 | 3 |
| 27 | 0.5 | 5 | 50 | 870 | 200 | 830 | 3 |
| 28 | 10 | 5 | 50 | 870 | 200 | 830 | 3 |
| 29 | 25 | 5 | 50 | 870 | 200 | 830 | 3 |
| 30 | 50 | 5 | 50 | 870 | 200 | 830 | 5 |
| 31 | 0.01 | 50 | 5 | 870 | 200 | 830 | 3 |
| 32 | 0.5 | 50 | 5 | 870 | 200 | 830 | 3 |
| 33 | 10 | 50 | 5 | 870 | 200 | 830 | 3 |
| 34 | 25 | 50 | 5 | 870 | 200 | 830 | 3 |
| 35 | 50 | 50 | 5 | 870 | 200 | 830 | 5 |

## T a b l e   1 4

| Sample No. | Critical temp. Tc end (K) | Transfer critical current density, Jct at 77K (A/cm$^2$) |
|---|---|---|
| 1 | 108 | 120 |
| 2 | 107 | 270 |
| 3 | 106 | 260 |
| 4 | 107 | 250 |
| 5 | 92 | 150 |
| 6 | 108 | 120 |
| 7 | 107 | 250 |
| 8 | 107 | 210 |
| 9 | 107 | 200 |
| 10 | 84 | 70 |
| 11 | 97 | 150 |
| 12 | 97 | 230 |
| 13 | 94 | 210 |
| 14 | 87 | 70 |
| 15 | Insulator | — |
| 16 | 103 | 180 |
| 17 | 103 | 180 |
| 18 | 102 | 180 |
| 19 | 94 | 180 |
| 20 | 82 | 75 |
| 21 | 94 | 180 |
| 22 | 94 | 180 |
| 23 | 93 | 210 |
| 24 | 81 | 75 |
| 25 | Insulator | — |
| 26 | 82 | 100 |
| 27 | 82 | 100 |
| 28 | 70 | — |
| 29 | Insulator | — |
| 30 | Insulator | — |
| 31 | 80 | 125 |
| 32 | 79 | 75 |
| 33 | 60 | — |
| 34 | Insulator | — |
| 35 | Insulator | — |

21 to 23) incorporated with less than 40 wt% of $Ca_2CuO_3$, $CaCu_2O_3$ and CaO in combination gave a Tc higher than 93K and a Jct as extremely high as 180 or above. They are of more practical use than those incorporated with only one species of the additives.

The above-mentioned examples are not limitative but may be modified according to the intended object and application within the scope of the invention. For example, the Bi compound to which the additives ($Ca_2CuO_3$ etc.) are added may be replaced by $Bi_2Sr_2Ca_2Cu_3O_y$ or a combination of this compound and the compound used in this example.

The combination of the additives ($Ca_2CuO_3$, $CaCu_2O_3$ and CaO) is not limited to that shown above; but a combination of $CaCu_2O_3$ and CaO, or a combination of $Ca_2CuO_3$ and CaO is also possible. In addition, the heat treatment and sintering may be carried out under other conditions ( temperature, time and atmosphere) than those employed in the above-mentioned examples. The starting materials are not specifically limited so long as they give rise to a desired oxide upon heating.

EXPLOITATION IN INDUSTRY:

The oxide superconducting material of the present invention will find use in the field of superconducting magnet, superconducting device, and power storage and transportation utilizing the superconducting properties etc.

**Claims**

1. An oxide superconducting material represented by the composition formula of $MBa_{2-x} Ca_x Cu_3O_{7-y}$ - (where M denotes at least one species of lanthanoid elements (excluding Ce, Pr, Pm, and Tb) and Sc and Y; and x is in the range of $0 \leqq x \leqq 1.8$ [excluding x = 1.0]).

2. An oxide superconducting material according to Claim 1, wherein x is in the range of 0.1 to 0.5.

3. An oxide superconducting material which contains 0.01-60 wt% of at least one species of $CaCu_2O_3$, $Ca_2CuO_3$ and CaO for one mole of a compound represented by the composition formula of $MBa_2Cu_3O_{7-y}$ where M denotes at least one species of lanthanoid elements (excluding Ce, Pr, Pm and Tb) and Sc and Y.

4. An oxide superconducting material according to any of Claims 1 to 3, wherein M is at least one species of La, Sc, and Y.

5. An oxide superconducting material which contains 0.01 to 60 wt% (in total) of at least one species of $Ca_2CuO_3$, $CaCu_2O_3$ and CaO for one mole of one or more than one species of $Tl_2Ca_2Ba_2Cu_3Oy$, $Tl, Ca_2Ba_2Cu_3Oy$, $(Tl,Pb),(Sr,Ca)_4Cu_3Oy$ and $(Tl,Pb),(Sr,Ca)_3Cu_2Oy$.

6. An oxide superconducting material which contains 0.01 to 60 wt% (in total) of at least one species of $Ca_2CuO_3$ , $CaCu_2O_3$ and CaO for one mole of one or more than one species of $(Bi,Pb)_2Sr_2Ca_2Cu_3Oy$ and $Bi_2Sr_2Ca_2Cu_3Oy$.

# INTERNATIONAL SEARCH REPORT

International Application No PCT/JP90/00443

**I. CLASSIFICATION OF SUBJECT MATTER** (if several classification symbols apply, indicate all) [6]

According to International Patent Classification (IPC) or to both National Classification and IPC

Int. Cl$^5$ C01G3/00, 15/00, 29/00

**II. FIELDS SEARCHED**

| Minimum Documentation Searched [7] | |
|---|---|
| Classification System i | Classification Symbols |
| IPC | C01G3/00, 15/00, 29/00, C04B35/00 |

| Documentation Searched other than Minimum Documentation to the Extent that such Documents are Included in the Fields Searched [8] |
|---|
| |

**III. DOCUMENTS CONSIDERED TO BE RELEVANT [9]**

| Category [*] | Citation of Document, [11] with indication, where appropriate, of the relevant passages [12] | Relevant to Claim No. [13] |
|---|---|---|
| X | JP, A, 63-230565 (International Business Machines Corp.), 27 September 1988 (27. 09. 88), Line 3, upper right column, page 3 (Family: none) | 1, 3 |
| X | JP, A, 63-270315 (TDK Corp.), 8 November 1988 (08. 11. 88), Line 12, upper right column, page 5 (Family: none) | 2 |
| P | JP, A, 1-208325 (Seiko Epson Corp.), 22 August 1989 (22. 08. 89). (Family: none) | 5 |
| P | JP, A, 1-215717 (Sumitomo Electric Industries, Ltd.), 29 August 1989 (29. 08. 89), (Family: none) | 5 |
| P | JP, A, 1-188456 (Kagaku Gijutsucho Kinzoku Zairyo Gijutsu Kenkyusho-cho), | 6 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| June 25, 1990 (25. 06. 90) | July 2, 1990 (02. 07. 90) |
| International Searching Authority | Signature of Authorized Officer |
| Japanese Patent Office | |

Form PCT/ISA/210 (second sheet) (January 1985)

| | | | |
|---|---|---|---|
| | FURTHER INFORMATION CONTINUED FROM THE SECOND SHEET | | |
| | 27 July 1989 (27. 07. 89)<br>& EP, A, 330305 | | |
| P | JP, A, 1-212227 (Nippon Telegraph &<br>Telephone Corp.),<br>25 August 1989 (25. 08. 89),<br>(Family: none) | | 6 |

**V.☐ OBSERVATIONS WHERE CERTAIN CLAIMS WERE FOUND UNSEARCHABLE [1]**

This international search report has not been established in respect of certain claims under Article 17(2) (a) for the following reasons:

1.☐ Claim numbers . ..., because they relate to subject matter not required to be searched by this Authority, namely:.

2.☐ Claim numbers , because they relate to parts of the international application that do not comply with the prescribed requirements to such an extent that no meaningful international search can be carried out, specifically:

3.☐ Claim numbers ... ..., because they are dependent claims and are not drafted in accordance with the second and third sentences of PCT Rule 6.4(a).

**VI.☐ OBSERVATIONS WHERE UNITY OF INVENTION IS LACKING [2]**

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)